# EUROPEAN PATENT APPLICATION

(11) **EP 4 687 164 A1**
(43) Date of publication of application: **04.02.2026**
(21) Application number: 25193065.7
(22) Date of filing: 31.07.2025
(51) Int. Cl.: H01G 4/10, G21H 1/06, H01G 4/12, H01G 4/232, H01G 4/30, H01G 4/33, H01G 4/38, H10F 39/10, H01G 4/012

(54) **STACK-TYPE CAPACITOR**

(30) Priority: 31.07.2024 KR 20240101654; 30.07.2025 KR 20250103906
(71) Applicant: LG Energy Solution, Ltd., Seoul 07335 (KR)
(72) Inventor: KIM, Dong Myung, 34122 Daejeon (KR); KIM, Je Young, 34122 Daejeon (KR); SHIN, Dong Myung, 34122 Daejeon (KR)
(74) Representative: BCKIP Part mbB

(57) **Abstract**

A stack-type capacitor includes: a plurality of cell sheets that are stacked; and a first external electrode of a first polarity and a second external electrode of a second polarity electrically connected to the plurality of cell sheets. Each of the plurality of cell sheets includes: a first material layer including either a non-conductor or a semiconductor; a second material layer having an electrical conductivity higher than the electrical conductivity of the first material layer and forming an interface with the first material layer; and a radiation source spaced from the interface and located within the first material layer.

## Description

### Technical Field

The present invention relates to a stack-type capacitor.

### Background of the Invention

Radiation emitted by a radioactive isotope can be absorbed through the surface of a p-n junction in a semiconductor and converted into electrical energy. The radiation generate electron-hole pairs in the space-charge region of the p-n junction semiconductor, and the generated carriers have voltage-current characteristics.

### Summary of the Invention

It is an object of the present invention to provide a stack-type capacitor capable of generating electrical energy with high energy density.

To accomplish the above technical problem, the present invention provides a stack-type capacitor in accordance with independent claim 1. Further preferred features are defined in dependent claims.

In accordance with the present invention, a stack-type capacitor comprises: a plurality of cell sheets. Each of the plurality of cell sheets may include: a substrate (S) comprising or carrying a first material layer formed of either a non-conductor material or a semiconductor material, and a cavity formed at a top major surface of the substrate (S). The plurality of cell sheets may further comprise a second material layer formed of a material having an electrical conductivity higher than the electrical conductivity of the first material layer. Herein, the first and the second material layer may form a p-n-junction at an interface therebetween. The plurality of cell sheets may include a radiation source accommodated within the cavity. The second material layer may be interposed between the first material layer and the radiation source. The plurality of cell sheets may be stacked on top of each other in a direction parallel to the substrate thickness direction. The stack-type capacitor may further comprise a first external electrode of a first polarity and a second external electrode of a second polarity electrically connected to the plurality of cell sheets.

Preferably, a bandgap of the second material layer is smaller than a bandgap of the first material layer.

The second material layer may have bandgap energy of 2.7 eV or greater.

Desirably, the second material layer may be a metal oxide layer.

For example, the metal oxide may include AMO₃, wherein A is at least one selected from the group consisting of La, Ba, Sr, and K, and M is at least one selected from the group consisting of Al, In, Ga, Ti, Sn, Hf, Ta, and Zr.

The metal oxide may include one or more selected from the group consisting of BaSnO₃, BaHfO₃, BaZrO₃, BaHf₁₋ₓTiₓO₃, Ba₁₋ₓLaₓSnO₃, Bi₄Ge₃O₁₂, Al₂O₃, Y₂O₃, La₂O₃, Ga₂O₃, Bi₂O₃, ZrO₂, HfO₂, Ta₂O₅, TiO₂, LaInO₃, LaGaO₃, SrZrO₃, SrHfO₃, SrTaO₇, LaIn₁₋ₓGaₓO₃, LaGaO₃, SrTiO₃, KTaO₃, HfSiO₄, Ta₃Ti₂Oₓ, and LaAlO₃, wherein 0<x<1.

Optionally, the metal oxide may include BaSnO₃.

The first material layer may include a diamond substrate, a SiC substrate, a GaN substrate, a Bi₂O₃/GeO₂ substrate, a Sm₂O₃/Bi₂O₃/GeO₂ substrate, a Sm₂O₃/Bi₂O₃/B₂O₃ substrate, a Sm₂O₃/Bi₂O₃/GeO₂/B₂O₃ substrate, a sapphire substrate, or a combination thereof.

Further, the first material layer and the second material layer may be arranged adjacent to each other along an extension direction of the top major surface of the substrate (S).

Furthermore, at least a part of the p-n-junction of a respective cell sheet may be aligned with at least a part of the p-n-junction of another cell sheet disposed directly on top or underneath, so that the p-n junctions substantially overlap each other.

Moreover, the second material layer may be accommodated in the cavity, at least partially surrounding the radiation source.

Besides, a plurality of cavities may be provided at the top major surface of the substrate (S). Further, a respective radiation source may be accommodated in each cavity.

Possibly, the cavity may extend from the top major surface till a bottom major surface of the substrate (S) positioned opposite to the top major surface in a substrate thickness direction.

Preferably, the cavity may be a through-hole having a cross-sectional shape of a circle or a regular polygon.

Optionally, the plurality of cavities may be arranged such that their respective centers are located at the vertices of an imaginary equilateral triangle.

The cavity may have, on the top major surface, a longitudinal extension greater than a width thereof.

Desirably, the second material layer may be accommodated in the cavity extending along the longitudinal extension of the cavity, facing a longitudinal side of the radiation source which extends along the longitudinal extension of the cavity.

For example, the cavity may include a stepped recess having a first recess at the top major surface of the substrate (S), and a through hole running from a bottom surface of the first recess toward the bottom major surface of the substrate (S). The radiation source may comprise a first portion disposed in the first recess, and a second portion in the through hole.

Possibly, the plurality of cell sheets may be electrically connected to each other by connectors.

According to one aspect of the present invention, the first material layers of cell sheets disposed directly on top and underneath may be electrically connected to each other. In addition or alternatively, the second material layers of cell sheets disposed directly on top and underneath may be electrically connected to each other.

Besides, the stack-type capacitor may further comprise a controller chip provided on one side of the plurality of cell sheets, being configured to control output of electrical energy generated.

Furthermore, the plurality of cell sheets may be embedded in a molding resin.

The stack-type capacitor of the present invention has the effect of generating electric energy with a high energy density.

The effects that may be obtained from the exemplary examples of the present invention are not limited to those mentioned above, and other effects not mentioned may be clearly derived and understood by one of ordinary skill in the art to which the exemplary examples of the present invention belong from the following description. That is, unintended effects of practicing the exemplary examples contained in the present disclosure may also be derived from the exemplary examples of the present invention by one of ordinary skill in the art.

### Brief Description of the Drawings

FIGS. 1a and 1b are side cross-sectional views illustrating stack-type capacitors according to embodiments of the present invention;
FIG. 1c is a cross-sectional view of a cell sheet of a capacitor according to an embodiment of the invention;
FIG. 1d is a cross-sectional view of a cell sheet of a capacitor according to a further embodiment of the invention;
FIGS. 2a to 2c are plan views of cell sheets of capacitors according to respective embodiments of the invention;
FIGS. 3a and 3b are plan views of cell sheets of capacitors according to respective embodiments of the invention;
FIG. 4 is a cross-sectional view of a stack-type capacitor according to a further embodiment of the invention;
FIG. 5 is a cross-sectional view of a stack-type capacitor according to a further embodiment of the invention;
FIG. 6a is a cross-sectional view of a stack-type capacitor according to a further embodiment of the invention;
FIG. 6b is a plan view of a cell sheet of the stack-type capacitor of FIG. 6a.
FIG. 6c is a cross-sectional view along line X-X of FIG. 6b.
FIG. 7 is a side cross-sectional view illustrating a stack-type capacitor according to a further embodiment of the present invention.
FIG. 8a is a side cross-sectional view illustrating a stack-type capacitor according to a further embodiment of the present invention.
FIG. 8b is a partially enlarged perspective view illustrating the second material layer, the radiation source, and the insulating layer of the stack-type capacitor of FIG. 8a.
FIG. 9 is a side cross-sectional view illustrating a stack-type capacitor according to a further embodiment of the present invention.
FIGS. 10a through 10h are side views illustrating a method of manufacturing a stack-type capacitor according to one embodiment of the present invention.

### Detailed Description of Exemplary Embodiments of the Invention

Hereinafter, preferred embodiments of the present invention will be described in detail with reference to the accompanying drawings. However, the embodiments of the present invention may be modified in many other ways, and it should not be construed that the present invention is limited by the embodiments described below. Like designations generally refer to like elements. Furthermore, the various elements and areas in the drawings are schematically depicted. Accordingly, the present invention is not limited by the relative sizes or spacing depicted in the accompanying drawings.

Terms such as "first," "second," and the like may be used to describe various components, but the components are not limited by such terms. These terms are used only for the purpose of distinguishing one component from another. For example, a first component may be named a second component, and vice versa, a second component may be named a first component, without departing from the scope of the concept of the present invention.

The terms used in this application is used to describe certain embodiments only and is not intended to limit the present invention. Expressions in the singular include the plural unless the context clearly indicates otherwise. In this application, expressions such as "includes" or "has" are intended to designate the presence of the features, numbers, steps, operations, components, parts, or combinations thereof described, and are not to be understood as precluding the possibility of the presence or addition of one or more other features, numbers, operations, components, parts, or combinations thereof.

Unless otherwise defined, all terms used herein, including technical and scientific terms, shall have the same meaning as commonly understood by one of ordinary skill in the art to which the concept of the present invention belongs. It is further understood that such terms, as commonly used and as defined in dictionaries, are to be construed to have a meaning consistent with their meaning in the context of the art to which they relate and are not to be construed in an unduly formal sense unless expressly defined herein.

When some embodiments can be implemented differently, certain processes may be performed in a sequence other than that described. For example, two successively described processes may be performed substantially simultaneously, or in the opposite order from the order described.

In the accompanying drawings, variations in the illustrated shapes may be expected, for example, due to manufacturing techniques and/or tolerances. Accordingly, embodiments of the present invention should not be construed as limited to the specific shape of the areas shown herein, and should include, for example, variations in shape resulting from manufacturing processes. All terms "and/or" used herein include each and every combination of one or more of the components mentioned. Further, the term "substrate" as used herein may refer to the substrate itself, or to a laminated structure including the substrate and any predetermined layers or films formed on its surface. Further, as used herein, the term "surface of the substrate" may refer to the exposed surface of the substrate itself, or to the outer surface of a predetermined layer or film formed on the substrate.

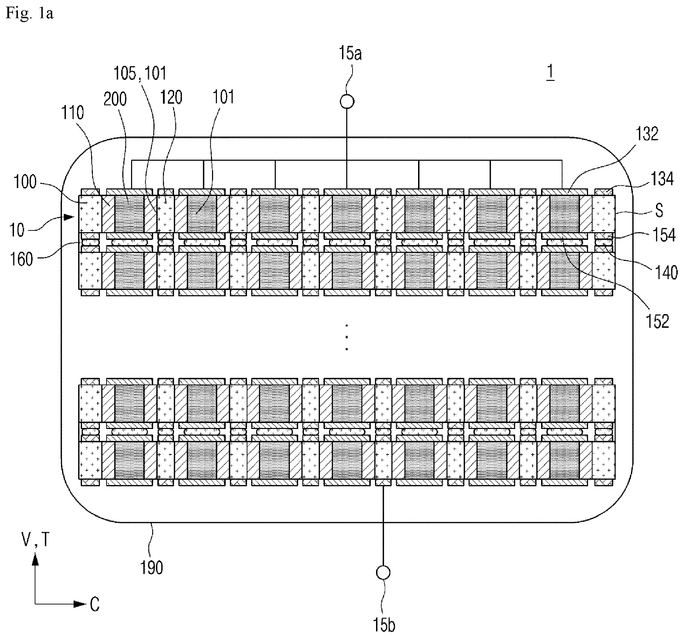

FIG. 1a is a side cross-sectional view exemplarily illustrating a stack-type capacitor 1.

Referring to FIG. 1a, the stack-type capacitor 1 may include a plurality of isotope electrode sheets, also referred to as cell sheets 10 that are stacked on top of one another.

Each of the plurality of cell sheets 10 may include a first material layer 100, a second material layer 110, and a radiation source 200.

The first material layer 100 may be a non-conductor (insulator, in other words) or a semiconductor. Optionally, the first material layer 100 may include a diamond substrate, a SiC substrate, a GaN substrate, a Bi₂O₃/GeO₂ substrate, a Sm₂O₃/Bi₂O₃/GeO₂ substrate, a Sm₂O₃/Bi₂O₃/B₂O₃ substrate, a Sm₂O₃/Bi₂O₃/GeO₂/B₂O₃ substrate, a sapphire substrate, or a combination thereof, which may be an undoped material.

Further optionally, the first material layer 100 may include a diamond substrate, a SiC substrate, a GaN substrate, a Bi₂O₃/GeO₂ substrate, a Sm₂O₃/Bi₂O₃/GeO₂ substrate, a Sm₂O₃/Bi₂O₃/B₂O₃ substrate, a Sm₂O₃/Bi₂O₃/GeO₂/B₂O₃ substrate, a sapphire substrate, or a combination thereof, which may be doped with dopants.

In some other embodiments, the first material layer 100 may have a formula of AMO₃ (where A is at least one species selected from the group consisting of La, Ba, Sr, and K, and M is at least one species selected from the group consisting of Al, In, Ga, Ti, Sn, Hf, Ta, and Zr).

Specifically, the first material layer 100 may include one or more selected from the group consisting of BaSnO₃, BaHfO₃, BaZrO₃, BaHf₁₋ₓTiₓO₃(where 0<x<1), Ba₁₋ₓLaₓSnO₃(where 0<x<1), Bi₄Ge₃O₁₂, Al₂O₃, Y₂O₃, La₂O₃, Ga₂O₃, Bi₂O₃, ZrO₂, HfO₂, Ta₂O₅, TiO₂, LaInO₃, LaGaO₃, SrZrO₃, SrHfO₃, SrTaO₇, LaIn₁₋ₓGaₓO₃(where 0<x<1), LaGaO₃, SrTiO₃, KTaO₃, HfSiO₄, Ta₃Ti₂Oₓ, and LaAlO₃ (where 0<x<1).

The first material layer 100 may include a semiconductor substrate. Alternatively, the first material layer 100 may include a non-conductor (insulator, in other words) substrate.

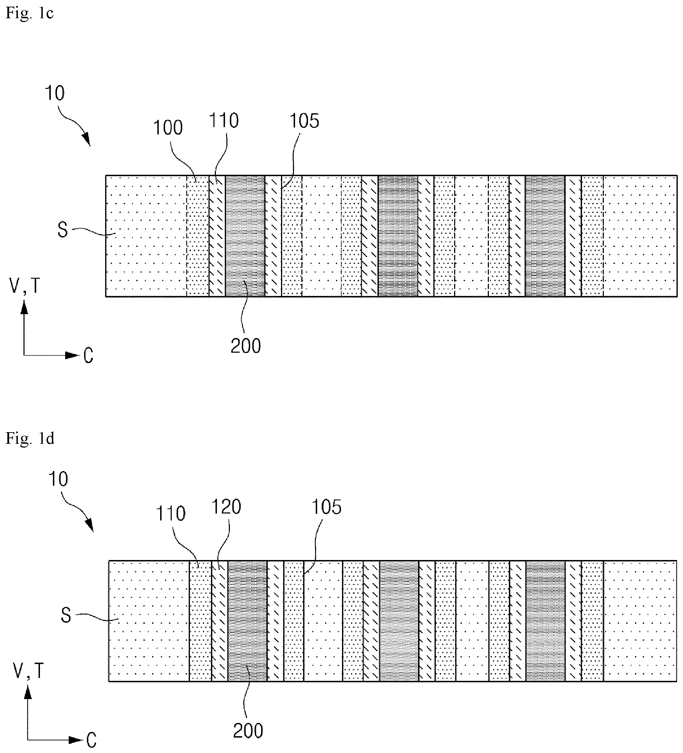

The first material layer 100 may form part of a substrate S. For example, as exemplarily shown in FIG. 1c, the first material layer 100 may be formed by distinct cross-sectional region of the substrate S. For example, the first material layer 100 may be formed by a local cross-sectional region in which a concentration of a dopant is increased or decreased compared to an adjacent cross-sectional region. Alternatively, the entire substrate S may form the first material layer 100. In this case, the substrate S may be formed, for example, by a semiconductor material or a non-conductive material, as described above.

Alternatively, as exemplarily shown in FIG. 1d, the substrate S may carry the first material layer 100. For example, the first material layer 100 may be disposed on an inner circumferential surface of a cavity 105 formed in the substrate S. In this case, the same materials stated above may be employed for the substrate S. However, it would also be possible to use a cheap, robust material for the substrate S such as a glass material or similar.

Generally, each cell sheet 10 may include a substrate S comprising a first surface and a second surface positioned opposite to the first surface in a substrate thickness direction T. Herein, the first surface and the second surface may be the top and bottom major surfaces of the first material layer 100, respectively. A substrate width direction C may extend perpendicular to the substrate thickness direction T. The cell sheets 10 may be stacked in a vertical direction V which is parallel to the substrate thickness direction T. The substrate S may be formed of one massive layer or sheet, as exemplarily shown in FIGS. 1a to 1c, 4, 5, and 6a. Alternatively, the substrate S may comprise a plurality of layers or sheets that are stacked in the substrate thickness direction T and bonded to each other (not shown).

As exemplarily shown in FIGS. 1a to 1c, 4, 5, and 6a, the substrate S may comprise a cavity 105 formed on the first surface. The radiation source 200 may be accommodated in the cavity 105. For example, the radiation source 200 may completely fill the cavity 105. In the following, examples are described, in which the substrate S as such forms the first material layer 100. In this case, the cavity 105 may be seen as formed in the first material layer 100. However, the invention is not limited to such a configuration, as already explained above. Therefore, all following explanations on the cavity 105 are also valid for configurations in which the first material layer 100 is distinctly formed within the substrate S or carried by the substrate S.

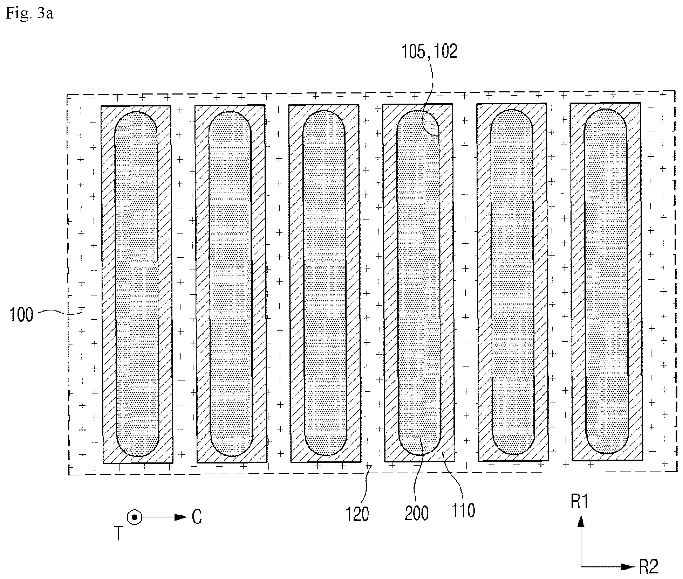

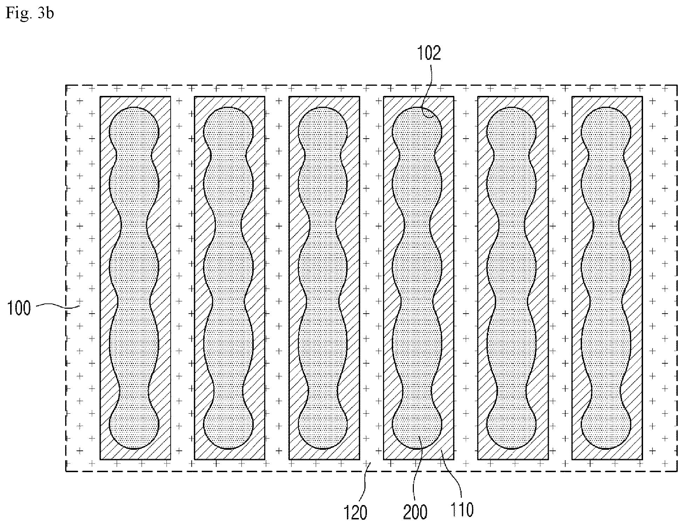

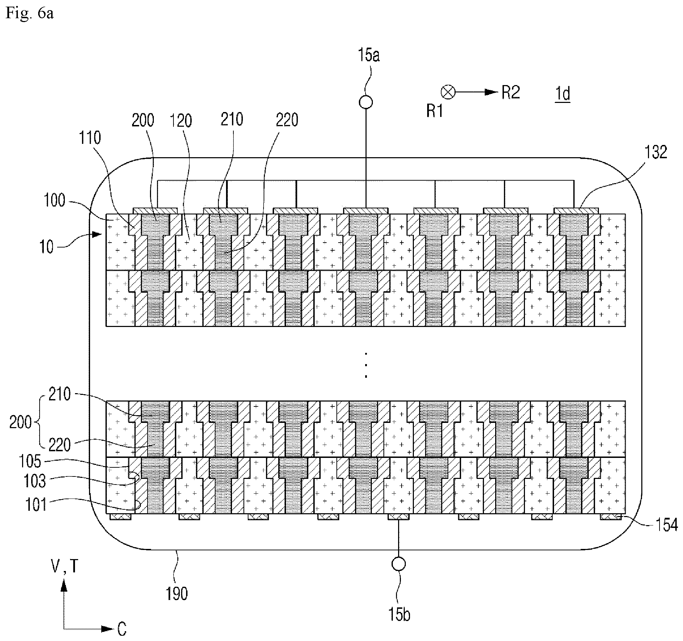

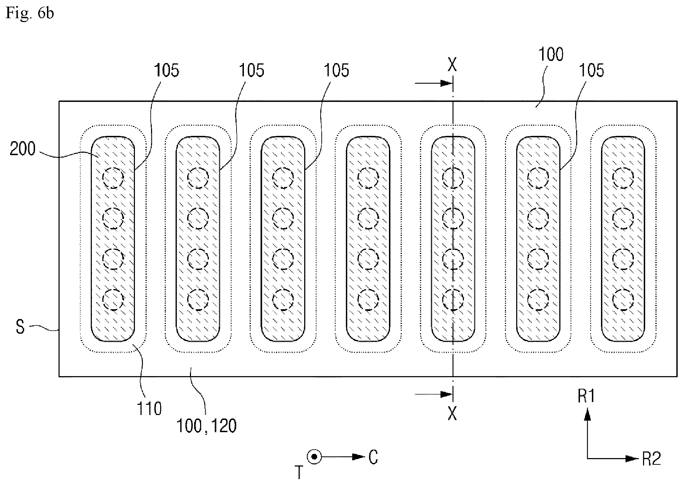

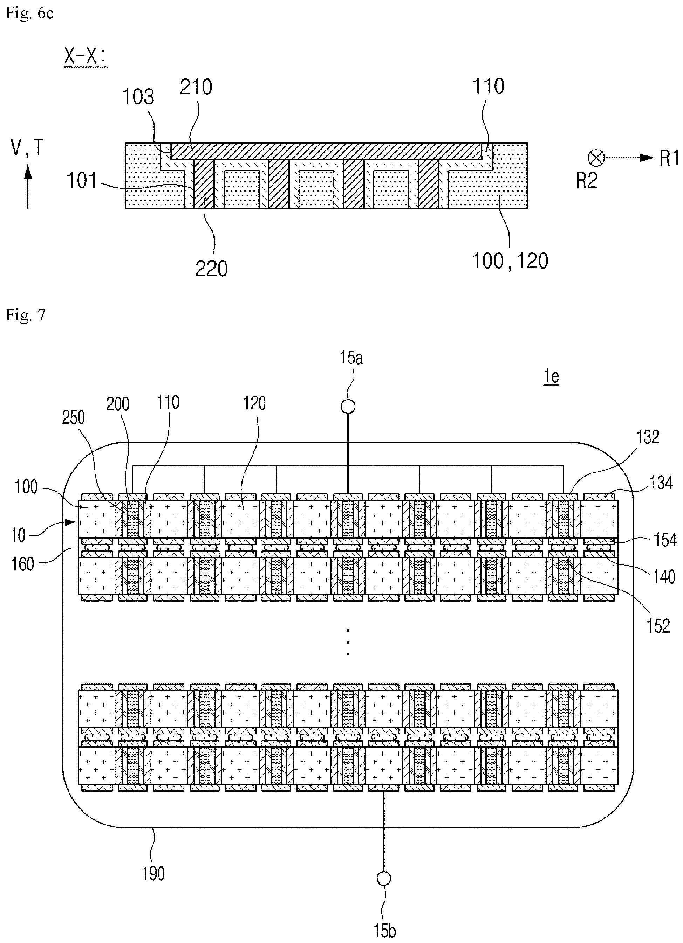

The first material layer 100 may include the cavity 105, e.g., as a concave part. Optionally, the cavity 105 may be a through-hole 101, as exemplarily shown in FIGS. 1a to 1c, 2a to 2c, 4 and 5, a longitudinal recess, as exemplarily shown in FIGS. 3a and 3b, or a through-opening with a varying cross-section as exemplarily shown in FIG. 6. The cavity 105 may have a certain extension between the two major surfaces of the first material layer 100. The cavity may fully penetrate the first material layer 100, that is, extend between the top major surface and the bottom major surface of the substrate S or the first material layer 100, or may only partially penetrate the first material layer 100.

The second material layer 110 may be disposed forming an interface with the first material layer 100. The second material layer 110 may be disposed at least partially within the cavity 105. Optionally, the second material layer 110 may be disposed completely within the cavity 105. The interface between the first material layer 100 and the second material layer 110 may extend at least partially in the substrate thickness direction T.

The second material layer 110 may be a material with a higher electrical conductivity compared to the first material layer 100. Optionally, the second material layer 110 may include a material having a smaller bandgap than the first material layer 100. For example, the second material layer 110 may include a material having a bandgap of about 2.7 eV or greater, about 3.0 eV or greater, or about 3.5 eV or greater.

The radiation source 200 may be located within the first material layer 100. Generally, the radiation source 200 may be disposed spaced apart from the interface within the cavity 105. Optionally, the radiation source 200 may be spaced apart from the interface within the first material layer 100.

The second material layer 110 may, for example, be provided conformally within the cavity 105. In this case, the second material layer 110 may have a recess space, which may, for example, correspond to the inner circumference of the cavity. For example, the second material layer 110 may be disposed with constant thickness, or substantially constant thickness, on the inner circumferential surface of the cavity 105.The radiation source 200 may be disposed within the recess space formed in the second material layer 110. Generally, the second material layer 110 may at least partially surround the radiation source 200, and the first material layer 100 may at least partially surround the second material layer 110. More generally, the second material layer 110 may be arranged between the radiation source 200 and the first material layer 100 in the substrate width direction C.

Optionally, the radiation source 200 may be disposed to extend through the full thickness of the first material layer 100. For example, the cavity 105 may extend between the first - or top major - surface and the second - or bottom major - surface of the substrate S, and the radiation source 200 may completely fill the cavity 105. The second material layer 110 may be interposed between the first material layer 100 and the radiation source 200. Specifically, the second material layer 110 may be disposed at a side of the radiation source 200, and the first material layer 100 may be disposed at a side of the second material layer 110. The first material layer 100 may include a substrate doping region 120 doped with impurities. The substrate doping region 120 may face the second material layer 110, i.e., may be arranged adjacent to the second material layer 110.

The first material layer 100 may include a diamond substrate, a SiC substrate, a GaN substrate, a Bi₂O₃/GeO₂ substrate, a Sm₂O₃/Bi₂O₃/GeO₂ substrate, a Sm₂O₃/Bi₂O₃/B₂O₃ substrate, a Sm₂O₃/Bi₂O₃/GeO₂/B₂O₃ substrate, a sapphire substrate, or a combination thereof.

The second material layer 110 may include a metal oxide having a bandgap energy of 2.7 eV or greater. In some embodiments, the metal oxide may have the formula AMO₃ , wherein A is one or more selected from the group consisting of La, Ba, Sr, and K, and M is one or more selected from the group consisting of Al, In, Ga, Ti, Sn, Hf, Ta, and Zr.

Specifically, the metal oxide may include one or more selected from the group consisting of BaSnO₃, BaHfO₃, BaZrO₃, BaHf₁₋ₓTiₓO₃(where 0<x<1), Ba₁₋ₓLaₓSnO₃(where 0<x<1), Bi₄Ge₃O₁₂, Al₂O₃, Y₂O₃, La₂O₃, Ga₂O₃, Bi₂O₃, ZrO₂, HfO₂, Ta₂O₅, TiO₂, LaInO₃, LaGaO₃, SrZrO₃, SrHfO₃, SrTaO₇, LaIn₁₋ₓGaₓO₃(where 0<x<1), LaGaO₃, SrTiO₃, KTaO₃, HfSiO₄, Ta₃Ti₂Oₓ, and LaAlO₃ (where 0<x<1).

The metal oxide is not only stable in high temperature and high humidity environments, but also has a high mobility of carriers, so it can efficiently absorb the radiation emitted by the radiation source 200 to provide high energy conversion efficiency. In addition, there is no inelastic collision in the carrier migration, so there is no energy loss and it is favorable for heat dissipation. For example, the metal oxide may have a high carrier mobility of 45 cm² /(V·s) or more, 80 cm² /(V·s) or more, 120 cm² /(V·s) or more, and even 300 cm² /(V·s) or more.

These metal oxides are materials that can be doped in any conductivity type and have the advantage of being able to provide high current or high voltage depending on the direction of the applied bias.

Optionally, the second material layer 110 may be doped with dopants of the first conductive type. The substrate doping region 120 may be doped with dopants of the second conductive type. The second material layer 110 and the substrate doping region 120 may generate electron-hole pairs by beta rays emitted by the radiation source 200. The first and second material layers 100, 110 may be doped with dopants of different conductive types.

For example, the dopant of the first conductive type may be an n-type dopant and the dopant of the second conductive type may be a p-type dopant. Alternatively, the dopant of the first conductive type may be a p-type dopant and the dopant of the second conductive type may be an n-type dopant. One of ordinary skill in the art will understand that, depending on the conductivity type of the dopants doped in each region, one of the second material layer 110 and the substrate doping region 120 may act as a cathode and the other may act as an anode. That is, if the dopant of the first conductive type is n-type dopant and the dopant of the second conductive type is p-type dopant, the second material layer 110 may act as an anode and the substrate doping region 120 may act as a cathode. Conversely, if the dopant of the first conductive type is a p-type dopant and the dopant of the second conductive type is an n-type dopant, the second material layer 110 may act as a cathode and the substrate doping region 120 may act as an anode.

An n-type doped region may be, for example, a semiconductor region doped with nitrogen (N), phosphorus (P), arsenic (As), or antimony, which are nitrogen group elements of the periodic table, or it may be a compound semiconductor doped with nitrogen (N), phosphorus (P), arsenic (As), or antimony, which are nitrogen group elements of the periodic table. As used herein, a compound semiconductor refers to a semiconductor composed of two or more elements, such as silicon carbide, silicon oxide, aluminum phosphide (AlP), aluminum arsenide (AlAs), gallium arsenide (GaAs), or gallium nitride (GaN).

A p-type doped region may be, for example, a semiconductor region doped with any of the boron group elements of the periodic table, such as boron (B), aluminum (Al), gallium (Ga), or indium (In), or may be a compound semiconductor doped with any of the boron group elements of the periodic table, such as boron (B), aluminum (Al), gallium (Ga), or indium (In).

Optionally, the second material layer 110 and substrate doping region 120 may include organics used in organic layers that receive light to generate power, such as in solar cell applications. For example, the second material layer 110 and the substrate doping region 120 may include a thiophene-like compound. Meanwhile, the second material layer 110 and the substrate doping region 120 may be an inorganic-organic hybrid, comprising any suitable mixture of inorganic and organic materials described above.

A depletion region may be formed near the interface where the second material layer 110 and the substrate doping region 120 contact each other.

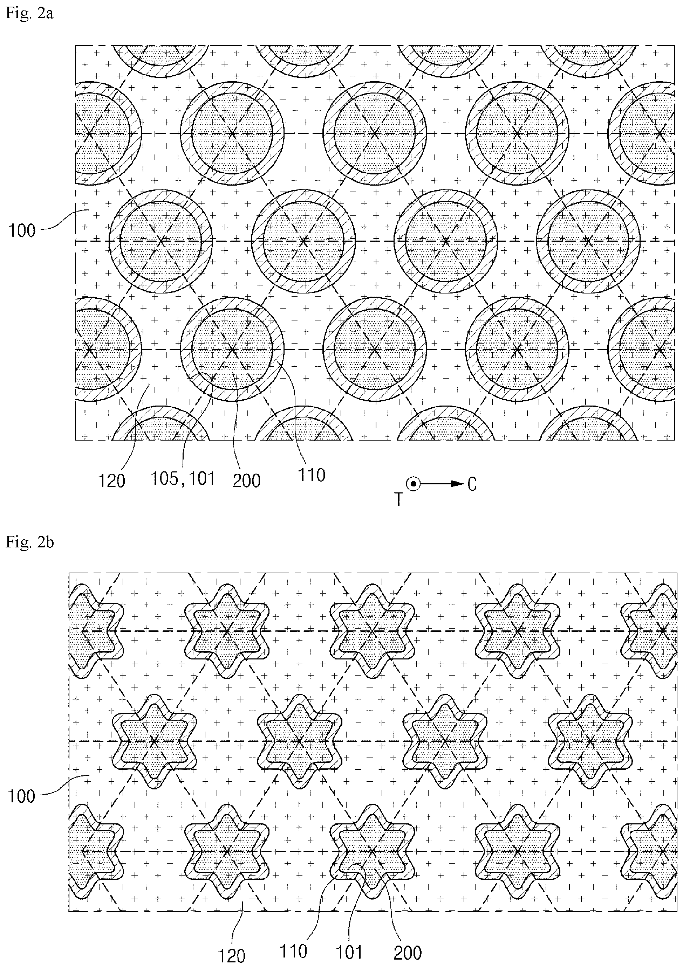

As already discussed above, the radiation source 200 may be provided within the cavity 105 which may be formed as a through-hole 101 running through the entire thickness of the first material layer 100. FIG. 2a to 2c are plan views exemplarily illustrating how the radiation source 200 may be disposed within the through-hole 101.

Referring to FIG. 2a, the first material layer 100 may be provided with a plurality of through-holes 101 extending from the top major surface to the bottom major surface of the first material layer 100, and the radiation source 200 may be disposed within the through-holes 101. As exemplarily shown in FIG. 2a, the through-holes 101 may have circular cross-sectional shape. However, the invention is not limited thereto, and the through-holes 101 may also have the cross-sectional shape of a regular polygon.

The through-holes 101 may be formed by any method known to those of ordinary skill in the art. For example, the through-holes 101 may be formed by anisotropic etching, isotropic etching, laser irradiation, or the like. Otherwise, the through-holes 101 may be formed by irradiating the substrate S with laser light. Alternatively, the through-holes 101 may be formed by reactive ion etching (RIE).

Optionally, the through-holes 101 may be arranged with a predetermined regularity or pattern. For example, as schematically shown in FIG. 2a, the through-holes 101 may be arranged so that their respective centers are located at the vertices of a series of imaginary equilateral triangles.

By arranging the through-holes 101 so that their centers are located at the vertices of imaginary equilateral triangles, the number of radiation sources 200 that can be accommodated per unit area can be maximized.

Preferably, the second material layer 110 may be disposed to surround the outer circumference of the radiation source 200. Further optionally, the substrate doping region 120 may be disposed to surround the outer circumference of the second material layer 110.

Referring to FIG. 2b, the sidewalls of the through-holes 101 may have irregularities. That is, the circumference of the through-holes 101 may have concave portions and convex portions. The interface of the radiation source 200 and the second material layer 110 may have irregularities. Preferably, the interface between the second material layer 110 and the substrate doping region 120 may have irregularities.

The second material layer 110 may have a substantially constant lateral thickness, as shown in FIG. 2b. Accordingly, the interface of the second material layer 110 and the substrate doping region 120 may have a shape corresponding to the interface of the radiation source 200 and the second material layer 110.

Since the side walls of the through-holes 101 have irregularities, the contact area of the radiation source 200 and the second material layer 110 can increase, thus improving the efficiency of the radiation source 200. Furthermore, the interface between the second material layer 110 and the substrate doping region 120 have an uneven, or corrugated, shape, the contact area between the second material layer 110 and the substrate doping region 120 increase, thereby improving the efficiency of the stack-type capacitor 1.

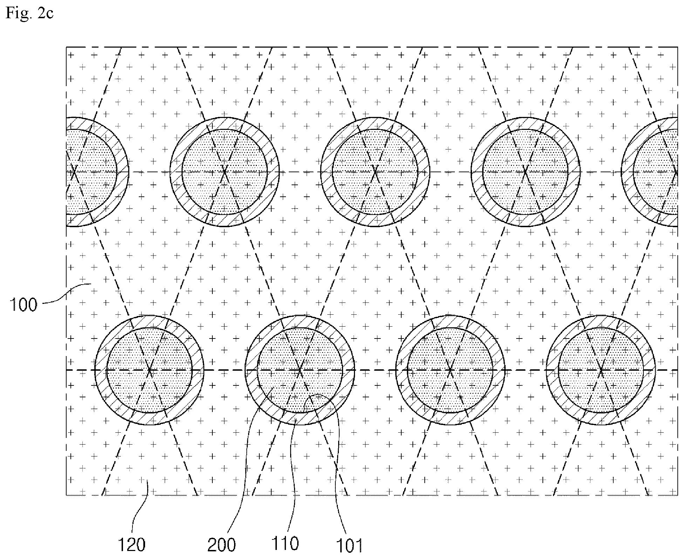

Referring to FIG. 2c, the centers of the through-holes 101 may be arranged such that they are positioned at the vertices of a series of imaginary isosceles triangles. That is, the centers of the through-holes 101 need not necessarily be positioned exactly at the vertices of the equilateral triangles, as is with the examples shown in Figs. 2a and 2b. Alternatively, the triangles, at whose vertices the respective centers of the through-holes 101 are positioned, may have different shapes from each other. In this case, the through-holes 101 may be arranged somewhat irregularly.

Optionally, the cavity 105 accommodating the radiation source 200 may be a longitudinal opening, e.g., a slit 102 extending through the first material layer 100. In the following, a cavity 105 having a longitudinal extension in a first direction R1 which is greater than its width in a second direction R2 perpendicular to the first direction R1, is referred to as a "slit". The first direction R1, generally, extends perpendicular to the substrate thickness direction T.

FIG. 3a is a plan view illustrating how the radiation source 200 may be disposed within the slit 102.

Referring to FIG. 3a, the first material layer 100 may include a plurality of slits 102. Said slits 102, preferably, extend parallel to each other in the first direction R1. As further exemplarily shown in FIG. 3a, the slits 102 may be arranged spaced apart from each other in the second direction R2 in regular intervals. Further, a respective radiation source 200 may be provided within each of the slits 102. Optionally, an outer circumference of the radiation source 200 may contact an inner circumference of the respective slit 102.

Optionally, the second material layer 110 may be disposed to face a longitudinally extended side of the radiation source 200, extending in the first direction R1. The second material layer 110 may face both sides of the longitudinal extension of the radiation source 200. The substrate doping region 120 may be disposed to face a longitudinally extended side of the second material layer 110 extending in the first direction R1.

Optionally, the second material layer 110 may be disposed to surround the outer circumference of the radiation source 200. Further optionally, the substrate doping region 120 may be disposed to surround the outer circumference of the second material layer 110.

Referring to FIG. 3b, longitudinal extensions, or side walls, of the slits 102 may have irregularities. That is, the longitudinal extensions of the slits 102 may have concave and convex portions. Thus, the interface of the radiation source 200 and the second material layer 110 may have irregularities.

Since the longitudinal extensions, or the side walls, of the slits 102 have irregularities, a contact area between the radiation source 200 and the second material layer 110 can be increased, thereby improving efficiency of the radiation source 200.

In FIGS. 1a to. 3b, the entirety of the first material layer 100 is shown as a substrate doping region 120, but the present invention is not limited to this. In FIGS. 1a to 3b, regions of different conductive types or dopant concentrations may be present within the first material layer 100, or regions may be present that are not doped with a particular conductivity. Optionally, the first material layer 100 may not be doped with dopants. In this case, the first material layer 100 may be an electrical non-conductor.

Referring again to FIG. 1a, the plurality of cell sheets 10 may be identical semiconductor dies stacked. Each of the cell sheets 10 may include a first upper electrode 132 provided on the side of the first - or top major - surface in contact with the second material layer 110 and a first lower electrode 152 provided on the side of the second - or bottom major - surface in contact with the second material layer 110. Further, each of the cell sheets 10 may include a second upper electrode 134 at the side of the first - or top major - surface in contact with the substrate doping region 120 and a second lower electrode 154 at the side of the second - or bottom major - surface in contact with the substrate doping region 120.

Each of the first upper electrode 132, the first lower electrode 152, the second upper electrode 134, and the second lower electrode 154 may act substantially as a current collector. Each of the first upper electrode 132, the first lower electrode 152, the second upper electrode 134, and the second lower electrode 154 is not particularly limited in type, size, and shape as long as it is electrically conductive without causing physical and chemical changes to the cell sheet 10. For example, each of the first upper electrode 132, the first lower electrode 152, the second upper electrode 134, and the second lower electrode 154 may be cylindrical, tetrahedral, hexahedral, torus, or pad-shaped. Furthermore, each of the first upper electrode 132, the first lower electrode 152, the second upper electrode 134, and the second lower electrode 154 may have a hollow center portion.

Further optionally, at the first surface, the second upper electrode 134 may, for example, be a continuous layer comprising openings arranged corresponding to the substrate doping regions 120, and the first upper electrodes 132 may be positioned in said openings. Similar, at the second surface, the second lower electrode 154 may, for example, be a continuous layer comprising openings arranged corresponding to the substrate doping regions 120, and the first lower electrodes 152 may be positioned in said openings.

Further, for example, each of the first upper electrode 132, the first lower electrode 152, the second upper electrode 134, and the second lower electrode 154 may include a metallic material such as gold (Au), silver (Ag), platinum (Pt), stainless steel, copper (Cu), aluminum (Al), nickel (Ni), or titanium (Ti), or may include a transparent oxide, such as fluorine (F)-doped tin oxide (FTO) or indium tin oxide (ITO, In₂O₃), or may include a carbon-based compound, such as carbon-nanotube, graphene, or graphene oxide.

The radiation source 200 may include a radioactive isotope. Radioactive isotopes are not limited as long as they decay and emit beta rays, but may include one or more selected from the group consisting of tritium (³H), calcium-45 (⁴⁵Ca), nickel-63 (⁶³Ni), copper-67 (⁶⁷Cu), strontium-90 (⁹⁰Sr), promethium-147 (¹⁴⁷Pm), osmium-194 (¹⁹⁴OS), thulium-171 (¹⁷¹Tm), tantalum-182 (¹⁸²Ta), cadmium-115 (¹¹⁵Cd), germanium-75 (⁷⁵Ge), cerium-141 (¹⁴¹Ce), cerium-144 (¹⁴⁴Ce), and tungsten-185 (¹⁸⁵W). Meanwhile, the radioactive isotope may emit only beta rays, or it may emit beta rays, including alpha rays, gamma rays, or the like.

The first lower electrode 152 of the cell sheet 10 positioned on top of another cell sheet 10 in the vertical direction V may be electrically connected to the first upper electrode 132 of the cell sheet 10 positioned directly underneath. Optionally, the first lower electrode 152 of the cell sheet 10 positioned on top of another cell sheet and the first upper electrode 132 of the cell sheet 10 positioned directly underneath may be connected by a connector 140, for example, a solder ball.

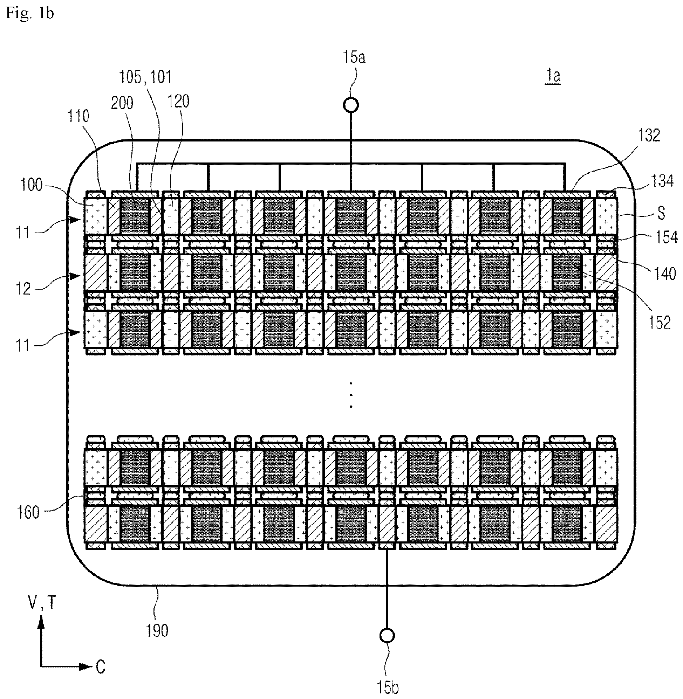

In one example, the connector 140 may include a conductive material. Here, the conductive material may include one or more selected from the group consisting of, for example, tin (Sn), indium (In), bismuth (Bi), antimony (Sb), copper (Cu), silver (Ag), zinc (Zn), and lead (Pb). The number, spacing, arrangement, and shape of the connectors 140 may be varied by design without limitation to those shown. Referring to FIGS. 1a and 1b, the connector 140 may have the form of a solder ball or a solder bump.

The space between the two vertically neighboring cell sheets 10 may be embedded by or filled with an insulator 160. The insulator 160 is not limited as long as it is any material having electrically insulating properties, but may include one or more selected from the group consisting of, for example, a silicate (e.g., TEOS), silicon nitride (SiN), hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, barium titanium oxide, strontium titanium oxide, yttrium oxide, and aluminum oxide.

The plurality of cell sheets 10 may be housed within a housing 190. The plurality of cell sheets 10 may also be electrically connected to an external load by conductors drawn outside through the housing 190.

Optionally, the housing 190 may further include an electromagnetic interference (EMI) shield (not shown) capable of shielding electromagnetic waves. The EMI shield may be formed on at least a portion of an inner surface and/or an outer surface of the housing 190. The EMI shield may include, for example, a metal such as copper, aluminum, a conductive polymer such as polyaniline, or a magnetic material such as iron oxide. The EMI shield may also be provided in the form of a sheet, mesh, applied layer, spray coating, non-woven fabric, tape, or fabric layer. By faithfully providing the EMI shield on the housing 190, the electromagnetic compatibility (EMC) of the stack-type capacitor 1 can be improved.

The first upper electrodes 132 of the cell sheet 10 disposed at the topmost cell sheet 10 of FIG. 1a may be electrically connected to each other and electrically connected to a first outer electrode 15a of first polarity. Further, the second lower electrodes 132 of the cell sheet 10 disposed at the lower most cell sheet 10 of FIG. 1a may be electrically connected to a second outer electrode 15b of second polarity. The first outer electrode 15a and second outer electrode 15b may be exposed to the outside of the housing 190 for connection to an external load.

Optionally, the second lower electrodes 154 of the cell sheet 10 disposed at the lower most cell sheet in FIG. 1a may be electrically connected to each other by surrounding the first lower electrode 152. In this case, the second lower electrodes 152 may be realized, for example, as a continuous layer, as explained above. Alternatively, the second lower electrodes 154 may be electrically connected to each other by separate conductive lines (not shown) and to the second outer electrode 15b exposed outside the housing 190.

FIG. 1b is a side cross-sectional view illustrating a further stack-type capacitor 1a.

Referring to FIG. 1b, the stack-type capacitor 1a may have a first cell sheet 11 and a second cell sheet 12 alternately and repeatedly stacked in the vertical direction V.

The first cell sheet 11 is substantially the same as the cell sheet 10 described with reference to FIG. 1a, and therefore will not be described in detail again.

The second cell sheet 12 is substantially identical to each component of the first cell sheet 11, but differs in that the conductive types of the dopants is reversed. That is, if the second material layer 110 of the first cell sheet 11 is p-type doped, the second material layer 110 of the second cell sheet 12 may be n-type doped. Conversely, if the second material layer 110 of the first cell sheet 11 is n-type doped, the second material layer 110 of the second cell sheet 12 may be p-type doped.

Similarly, if the substrate doping region 120 of the first cell sheet 11 is p-type doped, the substrate doping region 120 of the second cell sheet 12 may be n-type doped. Conversely, if the substrate doping region 120 of the first cell sheet 11 is n-type doped, the substrate doping region 120 of the second cell sheet 12 may be p-type doped.

Optionally, the first material layer 100 is not doped with dopants, in which case the substrate doping region 120 may not be present.

In the stack-type capacitor 1a of FIG. 1b, the first and second cell sheets 11, 12 are connected electrically in series, whereas in the stack-type capacitor of FIG. 1a, the cell sheets 10 are connected electrically in parallel. The stack-type capacitor 1a shown in FIG. 1b, therefore, can achieve a higher voltage of electrical energy. In the capacitor 1a of FIG. 1b,the number of unit cells corresponding to individual radiation sources 200 connected in series is increased.

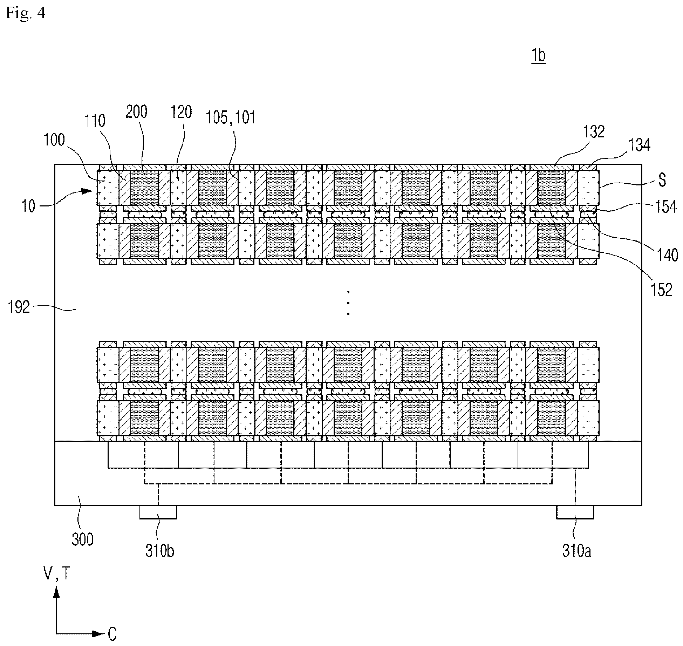

FIG. 4 is a side cross-sectional view illustrating another stack-type capacitor 1b.

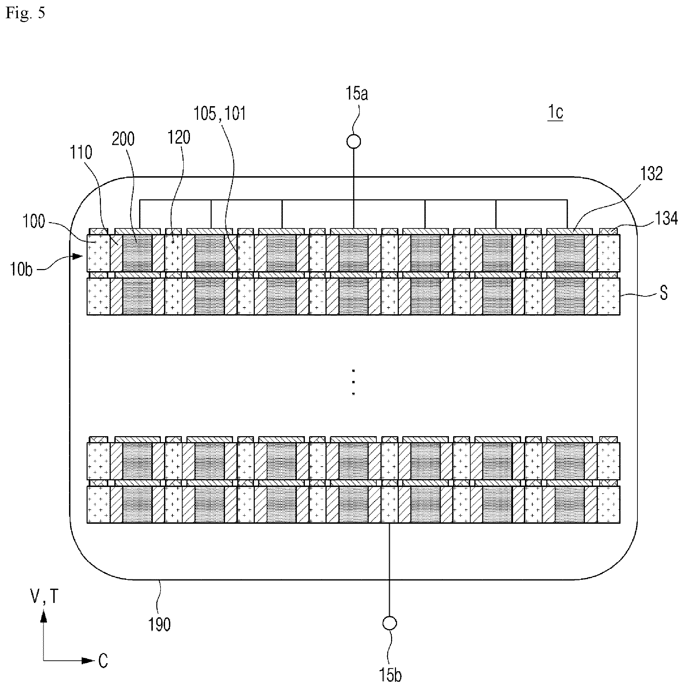

The stack-type capacitor 1b shown in FIG. 4 is substantially the same as the stack-type capacitor 1 described with reference to FIGS. 1a to 3b, but differs in that the plurality of cell sheets 10 are enclosed by or embedded in a molding member 192 and the plurality of cell sheets 10 are mounted on a controller chip 300. Accordingly, the following description will focus on these differences and omit description of the commonalities. It should be understood that any of the capacitors 1, 1a of FIGS. 1a to 3c as well as any one of the capacitors of FIGS. 5 and 6, which are described below, may also be mounted on a controller chip 300 and/or embedded in a molding member 192.

Referring to FIG. 4, the plurality of cell sheets 10 may be mounted on a controller chip 300. For example, the controller chip 300 may include a power management integrated circuit (PMIC) that outputs electrical energy generated by the plurality of stacked cell sheets 10 to the outside according to predetermined rules.

The plurality of cell sheets 10 may be molded by or embedded a molding member 192. The molding member 192 may include, for example, an epoxy molding compound (EMC).

The first upper electrode 132 and the second upper electrode 134 of the vertically uppermost cell sheet 10 may serve as dummy electrodes when the plurality of cell sheets 10 are brought together at the lower part and electrically connected to the controller chip 300 as shown in FIG. 4. Optionally, at least one of the first upper electrode 132 and the second upper electrode 134 of the topmost one among the plurality of cell sheets 10 may be exposed to the outside through the molding member 192.

Alternatively, the first upper electrode 132 and the second upper electrode 134 disposed on the topmost cell sheet 10 may be completely covered by the molding member 192.

The electrical energy generated by the plurality of cell sheets 10 may be supplied to an external load via external terminals 310a, 310b provided on the controller chip 300. In FIG. 4, the plurality of cell sheets 10 are shown mounted on the upper part of the controller chip 300, but the present invention is not limited to this.

FIG. 5 is a side cross-sectional view illustrating a further stack-type capacitor 1c.

Referring to FIG. 5, the stack-type capacitor 1c may include a plurality of cell sheets 10b stacked in the vertical direction V.

The cell sheet 10b differs from the cell sheet 10 of FIG. 1a in that the lower electrodes 152, 154 and the connector 140 are omitted. Accordingly, the following discussion will focus on these differences and omit discussion of the commonalities.

The cell sheet 10b includes a first upper electrode 132 and a second upper electrode 134 on the upper surface. Optionally, the cell sheets 10b of the plurality of stacked cell sheets 10b may have an identical configuration, obtained from identical semiconductor dies.

The first upper electrode 132 and the second upper electrode 134 of the cell sheet 10b lying underneath may be in direct contact with the bottom surfaces of the second material layer 110 and the substrate doping region 120, respectively, of the cell sheet 10b disposed on top. In other words, on a respective cell sheet 10b, first upper electrodes 132 and second upper electrodes 134 may only be provided on the first - or top major - surface of the substrate S, and the second - or bottom major - surface of a substrate S of a respective cell sheet 10b may be in electrical contact with the electrodes 132, 134 provided on the first - or top major - surface of the substrate S of a cell sheet 10b arranged directly underneath.

The stack-type capacitor 1c can be configured more compactly since the lower electrodes 152, 154 and the connector 140 are omitted, thereby increasing the energy density.

Further optionally, first material layers 100, i.e., doped regions 120 thereof, of neighboring cell sheets 10b and the second material layers 120 of neighboring cell sheets may be disposed in direct contact with each other, thereby omitting any electrodes between neighboring cell sheets within the stack.

FIG. 6a is a side cross-sectional view illustrating a further stack-type capacitor 1d. FIG. 6b is a plan view of a cell sheet of the stack-type capacitor of FIG. 6a. FIG. 6c is a cross-sectional view along line X-X of FIG. 6b.

Referring to FIG. 6a, the stack-type capacitor 1d may include a plurality of cell sheets 10c stacked in the vertical direction.

The cell sheets 10c shown in FIGS. 6a, 6b and 6c differ from those shown in FIG. 1a mainly in the configuration of the cavity 105. As exemplarily shown in FIG. 6a, the cavity 105 has a shape of a stepped recess. The cavity 105 may comprise a trench or recess 103 formed in the first surface of the substrate S. In addition, one or more through-holes 101 may extend between a bottom of the recess 103 and the second surface of the substrate S.

That is, cell sheet 10c may include a recess, or a trench, 103 extending along the upper surface of the first material layer 100 and a through-hole 101 extending from a bottom surface of the trench 103 to a lower surface of the first material layer 100. As exemplarily shown in FIG. 6b, the trench 103 may extend longitudinally in a first direction R1, and the through-hole 101 may extend vertically from a bottom surface of the trench 103. Optionally, a plurality of through-holes 101 may be arranged along the first direction R1 within a single trench 103, as exemplarily shown in FIGS. 6b and 6c.

Inside the recess 103 and in the plurality of through-holes 101, a radiation source 200 may be provided. The radiation source 200 may include a first portion 210 disposed within the recess 103. Further, the radiation source 200 may include a second portion 220 disposed within the through-hole 101, extending from the bottom of the trench 103 to the second - or bottom major - surface of the first material layer 100, that is, the second surface of the substrate S.

The width of the first portion 210 in the second direction R2 may be larger than the width of the second portion 220 in the second direction R2. Here, the second direction R2 is a direction perpendicular to the first direction R1. The width in the second direction R2 of the second material layer 110 and the radiation source 200 corresponding to the first portion 210 may be larger than the width in the second direction R2 of the second material layer 110 and the radiation source 200 corresponding to the second portion 220.

The second material layer 110 of the first material layer 100 may have a substantially constant thickness between the surfaces of the radiation sources 200.

FIG. 7 is a side cross-sectional view illustrating a further stack-type capacitor 1e according to the present invention. The capacitor 1e of FIG. 7 differs from the isotope capacitor 1 shown in FIG 1a in that it further includes a photon generating layer 250 around the radiation source 200 of the capacitor 1 shown in FIG. 1a; and this difference will be the focus of discussion below.

Referring to FIG. 7, the photon generating layer 250 may be any layer of material capable of emitting photons when irradiated with radiation particles, such as alpha particles, emitted from the radiation source 200. The radiation source 200 may be a material that emits alpha particles or beta particles. Examples of such materials have been described with reference to FIG. 1a, and therefore, they will not be described in detail herein.

For example, the photon generating layer 250 may employ materials such as, Ba₂Ca(BO₃)₂, BaHfO₃, BaI₂:Ce, BeO, BaF₂, BaMgF₄, Cs₂LiLuCi₆:Ce, K₂YF₅, KCaF₃, YI₃:Ce, but is not limited to these. Various examples of such photon generating layers 250 are disclosed in the following document: https://scintillator.lbl.gov/inorganic-scintillator-library/.

The photon generating layer 250 may emit photons in response to alpha or beta particles incident from the radiation source 200. The photons generated by the photon generating layer 250 may be incident on the junction region between the second material layer 110 and the substrate doping region 120, so that electrical energy may be generated by the photons.

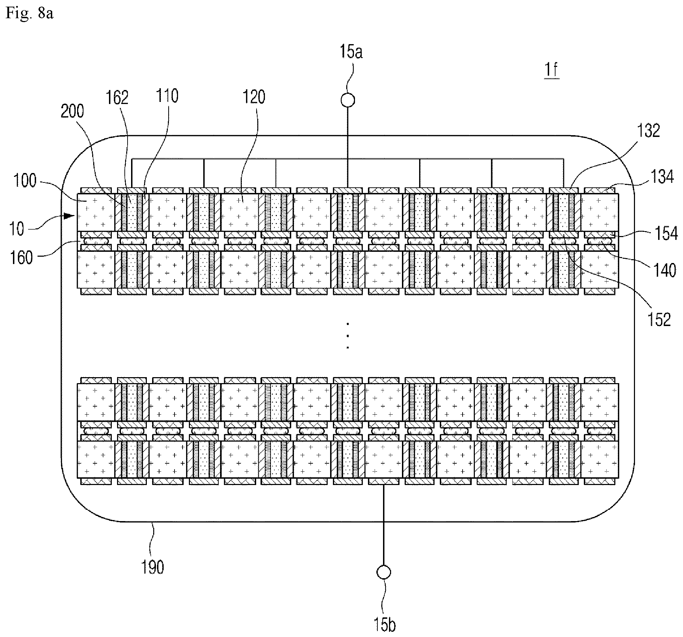

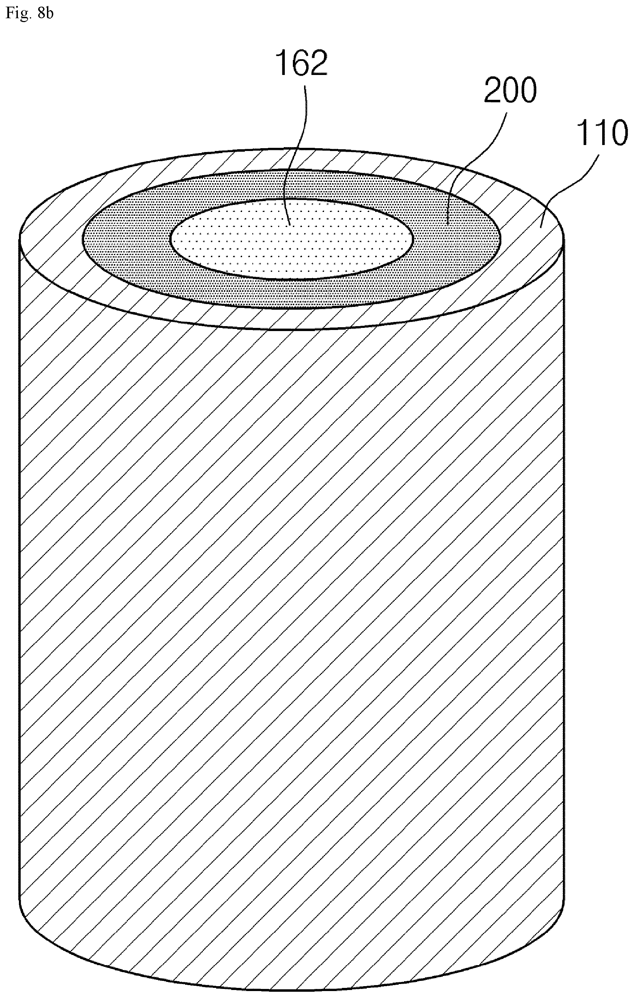

FIG. 8a is a side cross-sectional view illustrating a further stack-type capacitor 1f. FIG. 8b is a partially enlarged perspective view illustrating the second material layer 110, the radiation source 200, and the insulating layer 162 of the capacitor 1f. The capacitor 1f shown in FIGS. 8a and 8b differs from the capacitor 1 in FIG. 1a in that the radiation source 200 of the capacitor 1 has an annular shape, and the following discussion will focus on this difference.

Referring to FIGS. 8a and 8b, the radiation source 200 may have a hollow tube shape or a longitudinal shape with a central opening. Generally, the radiation source may extend along a longitudinal axis, and the central opening of the radiation source 200 may be formed along the longitudinal axis. For example, a central axis of the central opening may be parallel to or coaxial with the longitudinal axis. More generally, the radiation source 200 may have the shape of a cylinder, preferably a right cylinder, with a central opening. In this context, the cylinder is not limited to a circular cylinder. Rather, the bases of the cylinder may be of any shape, e.g., a circle, a polygon, an ellipse, etc.

Preferably, the central opening of the radiation source 200 may be filled by an insulating material 162. Alternatively, the central portion may be filled by the same material of which the first material layer 100 is formed or a semiconductor material derived therefrom. The radiation source 200 may have a substantially uniform thickness, e.g., a substantially uniform wall thickness, measured between an outer circumferential surface of the ration source 200 and an inner circumferential surface defining the cross-section of the central opening. As schematically shown in FIG. 8a, the radiation source 200 may extend along the interface with the second material layer 110.

Since the interior of the radiation source 200 is charged by the insulating material 162, the amount of the radiation source material required to form the radiation source 200 may be reduced. Since radiation source materials are expensive, forming the radiation source 200 in this hollow shape allows the capacitor 1f to be manufactured at a lower cost, without compromising the size of the contact area between the radiation source 200 and the second material layer 110.

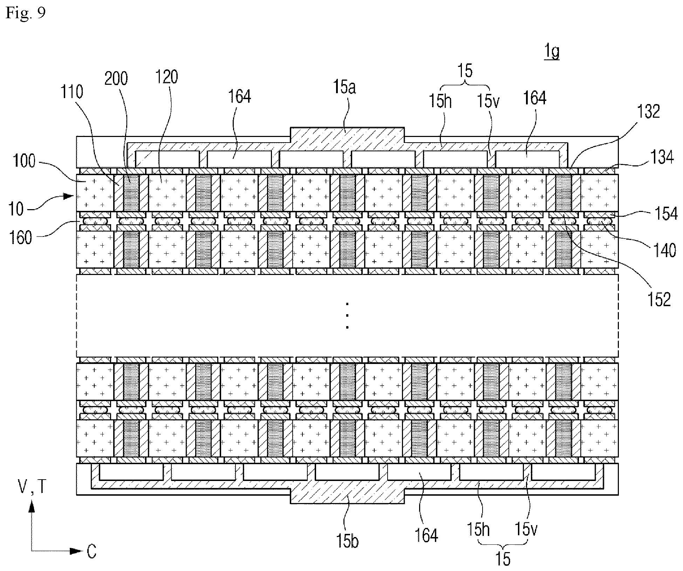

FIG. 9 is a side cross-sectional view illustrating a further stack-type capacitor 1g. The capacitor 1g shown in FIG. 9 differs from the capacitor 1 shown in FIG. 1a in the configuration of the external electrodes 15a, 15b, and the following discussion will focus on these differences.

Referring to FIG. 9, the capacitor 1g includes a first external electrode 15a and a second external electrode 15b for supplying electrical energy to an external load.

To connect with the first upper electrodes 132 of the cell sheet 10, the first external electrode 15a includes conductors 15. The conductors 15 may extend within an insulator 164 disposed on the uppermost cell sheet 10. The conductors 15 may only be electrically connected to the first upper electrodes 132.

The conductors 15 may comprise a first conductor 15h and a plurality of second conductors 15v, wherein the first conductor 15h and the plurality of second conductors 15v extend in different directions within the insulator 164. The plurality of second conductors 15v may electrically connect the first conductor 15h and to the respective first upper electrodes 132. The first conductor 15h may be physically and/or electrically connected to the first external electrode 15a. The first conductor 15h may extend in a horizontal direction, e.g., parallel to the substrate transverse direction C, and the plurality of second conductors 15v may extend in a vertical direction, e.g., traverse to the first conductor 15h to which they are connected. However, the present invention is not limited thereto.

Optionally, the second upper electrodes 134, provided to the cell sheet 10 closest to the first external electrode 15a, i.e., the topmost cell sheet 10, may be omitted.

The second external electrode 15b may also be electrically connected to the cell sheets 10 in a manner similar to the first external electrode 15a. A person of ordinary skill in the art will be able to conceive of the wiring connections between the second external electrode 15b and the cell sheets 10 by reference to the wiring connections between the first external electrode 15a and the cell sheets 10, described above.

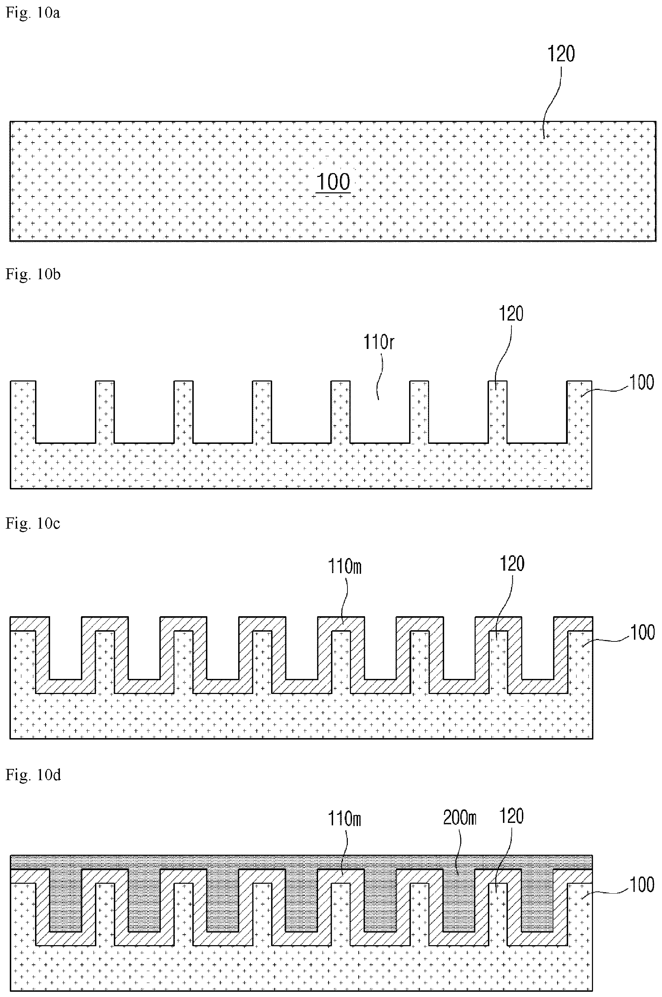

FIGS. 10a to 10h are side views illustrating a method of manufacturing a stack-type capacitor 1.

Referring to FIG. 10a, a first material layer 100 is provided. The first material layer 100 can include, for example, a material having an energy bandgap of about 2.5 eV or greater. In some embodiments, the first material layer 100 may include a diamond substrate, a SiC substrate, a sapphire substrate, or a combination thereof.

The first material layer 100 may be at least partially doped with a dopant. The dopant may be a dopant of a desired conductivity, and may have an opposite conductivity to the dopant doped in the metal oxide material layer 110m described later.

The dopant may be doped throughout the entirety of the first material layer 100, or it may be locally doped to form wells. Optionally, there may be regions within the interior of the first material layer 100 that are not doped with a particular conductivity. The dopant-doped regions form substrate doping regions 120. In the example of FIGS. 10a to 10h, the first material layer 100 may form part of a substrate S or itself may form the substrate. Alternatively, a substrate S may be provided without any dopant-doped regions, and the first material layer 100 may be applied to the substrate S, as will be explained below.

Referring to FIG. 10b, a plurality of recesses 100r can be formed in the first material layer 100.

The recess 100r may be formed, for example, by deep reactive ion etching (DRIE). However, the invention is not limited to this. The recess 100r may be in the form of a hole or a trench extending longitudinally in a first direction R1.

The sidewalls of the recess 100R include the substrate doping region 120.

The aspect ratio of the recess 100r can be determined by considering the thickness of the second material layer 110 to be formed, the film properties of the radiation source 200, and the like.

In the same way as described with reference to FIG. 10b, a recess 100r may be formed in the substrate S. Subsequently, the first material layer 100 may be disposed within the recess 100r, e.g., on an inner circumference of the recess 100r. The first material layer 100 may be formed by any known method. For example, the metal oxide material layer 110m may be formed by methods such as physical vapor deposition (PVD), chemical vapor deposition (CVD), or atomic layer deposition (ALD).

Referring to FIG. 10c, a metal oxide material layer 110m may be formed with a predetermined thickness on the interior of the recess 100r and on the upper surface of the first material layer 100.

The second material layer, e.g., in the form of a metal oxide material layer 110m, may be formed by any known method. For example, the metal oxide material layer 110m may be formed by methods such as physical vapor deposition (PVD), chemical vapor deposition (CVD), or atomic layer deposition (ALD). However, the invention is not limited to these. One of ordinary skill in the art will be able to select an appropriate deposition method based on the type of material to be deposited, the nature of the precursor or source, the step coverage required, and the like.

The metal oxide material layer 110m may be made of the same material as the second material layer 110 described above, which will not be described in detail herein. As previously described, the metal oxide material layer 110m may be doped with dopants of the desired conductive type. The substrate doping region 120 and the metal oxide material layer 110m may form a p-n junction at least at the sidewalls, i.e., along the circumference, of the recess 110r.

The metal oxide material layer 110m may be formed conformally in the interior of the recess 110r. Thus, the recess 110r has a remaining (or unfilled, or hollow) space after the formation of the metal oxide material layer 110m.

Referring to FIG. 10d, a radiation source material layer 200m is formed on the unfilled portion of the recess 110R and on the upper surface of the metal oxide material layer 110m.

The radiation source material layer 200m may be formed by any known method. For example, the radiation source material layer 200m may be formed by methods such as plating, PVD, CVD, or ALD. However, the present invention is not limited to these methods. A person of ordinary skill in the art will be able to select an appropriate deposition method, considering the type of material to be deposited, the nature of the precursor or source, the stepwise applicability required, and the like.

The radiation source material layer 200m may be made of the same material as the radiation source 200 described above, which will not be described in detail herein.

The radiation source material layer 200m may fill up the space remaining in the recess 110r after the formation of the metal oxide material layer 110m.

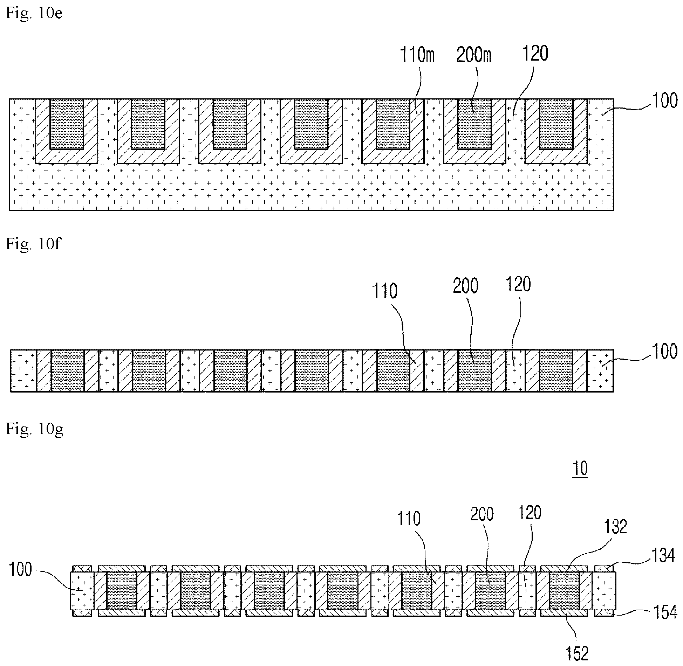

Referring to FIG. 10e, the radiation source material layer 200m and the metal oxide material layer 110m are partially removed so that the upper surface of the first material layer 100 is exposed.

In some embodiments, portions existing on the radiation source material layer 200m and on the upper surface of the first material layer 100 of the metal oxide material layer 110m may be removed.

The radiation source material layer 200m and the metal oxide material layer 110m may be partially removed and leveled by dry etching, wet etching, and/or chemical mechanical polishing (CMP).

Referring to FIG. 10f, the lower part of the first material layer 100 may be partially removed. The lower surface of the first material layer 100 may be removed until the lower surface of the radiation source 200 is exposed.

The lower part of the first material layer 100 may be partially removed and leveled by dry etching, wet etching, and/or CMP. As the lower surface of the first material layer 100 is removed, the lower part of the metal oxide material layer 110m and the radiation source material layer 200m may be partially removed. By partially removing the lower part of the first material layer 100, the radiation source 200 is allowed to penetrate or extend through the first material layer 100 along the entire thickness thereof.

Referring to FIG. 10g, a first upper electrode 132 and a first lower electrode 152 may be formed on the upper and lower surfaces of the second material layer 110, respectively, and a second upper electrode 134 and a second lower electrode 154 may be formed on the upper and lower parts of the substrate doping region 120, respectively.

The electrodes 132, 152, 134, 154 may be formed, for example, by electroplating or electroless plating. Optionally, only some of the electrodes 132, 152, 134, 154 may be formed.

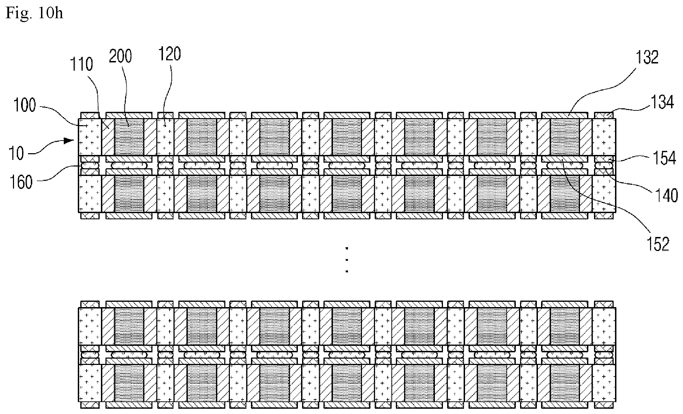

Referring to FIG. 10h, the cell sheets 10 may be repeatedly stacked. The stacked cell sheets 10 may be electrically connected to each other by a connector 140.

Optionally, an insulator 160 may be provided between two neighboring cell sheets 10. The insulator 160 has been described above with reference to FIG. 1a and will not be described in detail herein.

The plurality of stacked cell sheets 10 are then electrically connected and housed within the housing 190 to obtain a stack-type capacitor 1 as shown in FIG. 1a.

Although embodiments of the invention have been described in detail above, one of ordinary skill in the art to which the present invention belongs will be able to make many modifications to the present invention without departing from the scope of the present invention as defined in the appended claims. Accordingly, further modifications of the present invention will not depart from the scope of the present invention.

## Claims

1. A stack-type capacitor (1, 1a, 1b, 1c, 1d), comprising:
a plurality of cell sheets (10, 10b, 10c, 11, 12), each of the plurality of cell sheets including:
a substrate (S) comprising or carrying a first material layer (100) formed of either a non-conductor material or a semiconductor material, and a cavity (105) formed at a top major surface of the substrate (S),
a second material layer (110) formed of a material having an electrical conductivity higher than the electrical conductivity of the first material layer (100), wherein the first and the second material layer (100, 110) form a p-n-junction at an interface therebetween, and
a radiation source (200) accommodated within the cavity (105), wherein the second material layer (110) is interposed between the first material layer (100) and the radiation source (120),
wherein the plurality of cell sheets (10, 10b, 10c, 11, 12) are stacked on top of each other in a direction parallel to the substrate thickness direction; and
a first external electrode (15a) of a first polarity and a second external electrode (15b) of a second polarity electrically connected to the plurality of cell sheets (10, 10b, 10c, 11, 12).

2. The stack-type capacitor (1, 1a, 1b, 1c, 1d) of claim 1, wherein a bandgap of the second material layer (110) is smaller than a bandgap of the first material layer (100).

3. The stack-type capacitor (1, 1a, 1b, 1c, 1d) of claim 1 or 2, wherein the second material layer (110) has bandgap energy of 2.7 eV or greater.

4. The stack-type capacitor (1, 1a, 1b, 1c, 1d) of any one of the preceding claims,
wherein the second material layer (110) is a metal oxide layer.

5. The stack-type capacitor (1, 1a, 1b, 1c, 1d) of claim 4, wherein the metal oxide includes AMO₃, wherein A is at least one selected from the group consisting of La, Ba, Sr, and K, and M is at least one selected from the group consisting of Al, In, Ga, Ti, Sn, Hf, Ta, and Zr.

6. The stack-type capacitor (1, 1a, 1b, 1c, 1d) of claim 4 or 5, wherein the metal oxide includes one or more selected from the group consisting of BaSnO₃, BaHfO₃, BaZrO₃, BaHf₁₋ₓTiₓO₃, Ba₁₋ₓLaₓSnO₃, Bi₄Ge₃O₁₂, Al₂O₃, Y₂O₃, La₂O₃, Ga₂O₃, Bi₂O₃, ZrO₂, HfO₂, Ta₂O₅, TiO₂, LaInO₃, LaGaO₃, SrZrO₃, SrHfO₃, SrTaO₇, LaIn₁₋ₓGaₓO₃, LaGaO₃, SrTiO₃, KTaO₃, HfSiO₄, Ta₃Ti₂Oₓ, and LaAlO₃,
wherein 0<x<1.

7. The stack-type capacitor (1, 1a, 1b, 1c, 1d) of any one of claims 4 to 6, wherein the metal oxide includes BaSnO₃.

8. The stack-type capacitor (1, 1a, 1b, 1c, 1d) of any one of the preceding claims, wherein the first material layer includes a diamond substrate, a SiC substrate, a GaN substrate, a Bi₂O₃/GeO₂ substrate, a Sm₂O₃/Bi₂O₃/GeO₂ substrate, a Sm₂O₃/Bi₂O₃/B₂O₃ substrate, a Sm₂O₃/Bi₂O₃/GeO₂/B₂O₃ substrate, a sapphire substrate, or a combination thereof.

9. The stack-type capacitor (1, 1a, 1b, 1c, 1d) of any one of the preceding claims, wherein the first material layer (100) and the second material layer (110) are arranged adjacent to each other along an extension direction of the top major surface of the substrate (S).

10. The stack-type capacitor (1, 1a, 1b, 1c, 1d) of any one of the preceding claims, wherein at least a part of the p-n-junction of a respective cell sheet (10, 10b, 10c, 11, 12) is aligned with at least a part of the p-n-junction of another cell sheet (10, 10b, 10c, 11, 12) disposed directly on top or underneath, so that the p-n junctions substantially overlap each other.

11. The stack-type capacitor (1, 1a, 1b, 1c, 1d) of any one of the preceding claims, wherein the second material layer (110) is accommodated in the cavity (105), at least partially surrounding the radiation source (200).

12. The stack-type capacitor (1, 1a, 1b, 1c, 1d) of any one of the preceding claims, wherein a plurality of cavities (105) is provided at the top major surface of the substrate (S), and a respective radiation source (120) is accommodated in each cavity (105).

13. The stack-type capacitor (1, 1a, 1b, 1c, 1d) of any one of the preceding claims, wherein the cavity (105) extends from the top major surface till a bottom major surface of the substrate (S) positioned opposite to the top major surface in a substrate thickness direction (T).

14. The stack-type capacitor (1, 1a, 1b, 1c) of claim 13, wherein the cavity (105) is a through-hole (101) having a cross-sectional shape of a circle or a regular polygon.

15. The stack-type capacitor (1, 1a, 1b, 1c) of any one of claims 12 to 14, insofar as dependent upon claim 12, wherein the plurality of cavities (105) is arranged such that their respective centers are located at the vertices of an imaginary equilateral triangle.

16. The stack-type capacitor (1, 1a, 1b, 1c) of any one of claims 1 to 13, wherein the cavity (105) has, on the top major surface, a longitudinal extension greater than a width thereof.

17. The stack-type capacitor (1, 1a, 1b, 1c) of claim 16, insofar as dependent upon claim 11, wherein the second material layer (110) is accommodated in the cavity (105) extending along the longitudinal extension of the cavity (105), facing a longitudinal side of the radiation source (200) which extends along the longitudinal extension of the cavity (105).

18. The stack-type capacitor (1d) of any one of claims 1 to 13, wherein the cavity (105) includes a stepped recess having a first recess (103) at the top major surface of the substrate (S), and a through hole (101) running from a bottom surface of the first recess (103) toward the bottom major surface of the substrate (S), and
the radiation source (200) comprises a first portion (210) disposed in the first recess (103), and a second portion (220) in the through hole (101).

19. The stack-type capacitor (1, 1a, 1b) of any one of the preceding claims, wherein the plurality of cell sheets (10, 10a, 11, 12) are electrically connected to each other by connectors (140).

20. The stack-type capacitor (1, 1a, 1b, 1c, 1d) of any one of the preceding claims, wherein the first material layers (100) of cell sheets (10, 10b, 10c, 11, 12) disposed directly on top and underneath are electrically connected to each other, and the second material layers (110) of cell sheets (10, 10b, 10c, 11, 12) disposed directly on top and underneath are electrically connected to each other.

21. The stack-type capacitor (1, 1a, 1b, 1c, 1d) of any one of the preceding claims, further comprising a controller chip provided on one side of the plurality of cell sheets (10, 10b, 10c, 11, 12), being configured to control output of electrical energy generated.

22. The stack-type capacitor (1, 1a, 1b, 1c, 1d) of any one of the preceding claims, wherein the plurality of cell sheets (10, 10b, 10c, 11, 12) are embedded in a molding resin (192).
